# FASCICULE DE BREVET EUROPEEN

(11) **EP 2 143 231 B1**
(45) Date de publication et mention de la délivrance du brevet: **31.08.2016**
(21) Numéro de dépôt: 08787917.7
(22) Date de dépôt: 04.04.2008
(51) Int. Cl.: H04L 7/027, H04L 7/033, H03L 7/24

(54) **DISPOSITIF D'EXTRACTION D'HORLOGE ET DE DONNEES NUMERIQUES SANS REGLAGE EXTERNE**
VORRICHTUNG ZUR RÜCKGEWINNUNG DES TAKTES UND DIGITALER DATEN OHNE EXTENRE REGELUNG
DIGITAL DATA AND CLOCK EXTRACTION DEVICE REQUIRING NO EXTERNAL CONTROL

(30) Priorité: 06.04.2007 FR 0702555
(43) Date de publication de la demande: 13.01.2010
(73) Titulaire: Centre National d'Etudes Spatiales (C.N.E.S.), 75039 Paris Cedex 01 (FR)
(72) Inventeur: PIGNOL, Michel, F-31000 Toulouse (FR); NEVEU, Claude, F-31600 Saint Clar de Rivière (FR); DEVAL, Yann, F-33800 Bordeaux (FR); BEGUERET, Jean-Baptiste, F-33400 Talence (FR); MAZOUFFRE, Olivier, F-33360 Latresne (FR)
(74) Mandataire: Cabinet BARRE LAFORGUE & associés
(86) Numéro de dépôt international: PCT/FR2008/000478
(87) Numéro de publication internationale: WO 2008/139063

(56) Documents cités:
- EP-A- 1 006 660
- WO-A-97/41665
- FR-A- 2 838 265
- US-A- 3 010 073
- US-A- 3 609 408
- US-B1- 6 317 008
- US-B2- 6 924 705

## Description

L'invention concerne un dispositif d'extraction d'horloge et de données numériques à partir d'un signal série en bande de base, dit signal reçu, représentatif des données numériques, et codé avec un signal d'horloge présentant une fréquence d'horloge bits fsr correspondant au moins sensiblement à une fréquence nominale fn.

Dans de nombreuses applications, et en particulier dans le domaine des très hautes fréquences (fréquences nominales fn supérieures à 500 MHz, pouvant être supérieures à 10 GHz, pouvant aller actuellement jusqu'à 40 GHz et même dépasser très largement ces valeurs dans le futur) correspondant à des très hauts débits (supérieurs à 500 Mbits/s, pouvant être supérieurs à 10 Gbits/s, et pouvant aller jusqu'à 40 Gbits/s pour les standards SONET OC-768 et SDH STM-256 et pouvant dépasser très largement ces valeurs dans le futur), on transmet sur un canal de transmission (dont la technologie de réalisation peut être quelconque : électrique, optique, radiofréquence,...) d'une liaison série en bande de base un signal incorporant des données numériques mixées avec un signal d'horloge, de façon à éviter d'avoir à transmettre ces deux informations sur deux canaux différents. Ceci permet d'éviter tout appairage délicat de la longueur des cheminements des signaux. Avec de tels signaux, au niveau du récepteur, il est nécessaire d'extraire du signal reçu, de nature analogique, d'une part les valeurs des données numériques et, d'autre part, le signal d'horloge correspondant à ces données. Pour obtenir les valeurs des données, on échantillonne le signal reçu à partir du signal d'horloge préalablement extrait des données.

La solution la plus usuelle pour réaliser un tel dispositif d'extraction d'horloge et de données consiste à utiliser des circuits comprenant au moins une boucle à verrouillage de phase, dite PLL, qui comprend principalement, à la sortie d'un circuit générant des impulsions correspondant aux fronts du signal reçu, un comparateur de phase délivrant un signal de consigne à un oscillateur contrôlé en tension, dit VCO, via un filtre de boucle. Le VCO fournit un signal d'horloge interne à une bascule de décision, constituant un circuit d'échantillonnage qui extrait les données du signal reçu. Ces circuits PLL traditionnels, qui utilisent des oscillateurs, des comparateurs phase/fréquence et des diviseurs numériques haute fréquence, présentent divers inconvénients. Ils nécessitent une référence de fréquence externe. Ils nécessitent une synchronisation au démarrage par un préambule de données devant nécessairement être présent dans le signal reçu et qui peut comprendre plusieurs milliers de bits, ce qui n'est pas admissible dans certaines applications. L'optimisation de leur fonctionnement et leur réalisation est d'une grande complexité, de nombreux paramètres interdépendants et contradictoires devant être pris en compte, notamment en ce qui concerne le circuit comparateur phase/fréquence. En conséquence, il est en particulier très difficile d'atteindre les limites hautes en fréquence de fonctionnement qui seraient théoriquement possibles. Ils ont une consommation énergétique très importante. Leur réalisation analogique est fortement dépendante de la technologie de fabrication des composants semi-conducteurs mise en oeuvre... En conséquence, la réalisation d'un circuit PLL pour réaliser une fonctionnalité d'extraction d'horloge nécessite l'intervention de spécialistes des circuits analogiques ayant une grande expérience et un grand savoir-faire, et, d'autre part, nécessite des durées de développement importantes, à renouveler régulièrement à chaque évolution de la technologie, ce qui, du point de vue des contraintes actuelles d'exploitation à l'échelle industrielle, est un handicap important.

Une autre solution connue pour réaliser l'extraction d'horloge et de données est fondée sur l'utilisation d'une boucle à verrouillage de délais, dite DLL. Ces circuits nécessitent cependant un code spécifique en ce qui concerne le signal reçu, en particulier avec un bit de démarrage et un bit de stop pour former une transition de référence dans chaque mot (ce qui réduit la fréquence de transmission maximale accessible pour les données, typiquement de 33 % avec des données utiles sur 8 bits et un code tel que le 8B/12B). En outre, les données récupérées présentent une dérive de phase (« jitter ») relativement importante, pouvant conduire à un taux d'erreurs de bits non négligeable. Également, un tel circuit DLL est très sensible aux bruits sur le signal reçu. Enfin, cette technique mise en oeuvre par des composants numériques est difficilement compatible avec des vitesses de transmission extrêmement élevées.

FR 2838265 a proposé une solution consistant à utiliser un oscillateur à injection, c'est-à-dire un oscillateur verrouillé en injection sur la fréquence de fronts du signal reçu, dans un circuit en boucle ouverte. Pour ce faire, l'oscillateur à injection est un oscillateur à résistances négatives utilisant une paire couplée de transistors MOS, et reçoit un signal d'impulsions de synchronisation cadencé à la fréquence d'horloge bits fsr du signal reçu, ce signal d'impulsion étant émis par un générateur d'impulsions en courant. Cet oscillateur verrouillé en injection présentant une fréquence d'oscillations libres fos, a la faculté de se verrouiller sur le signal d'impulsions si la fréquence de ce dernier est dans sa plage de fonctionnement, dite plage de capture. Il fournit alors un signal d'horloge dont la fréquence correspond exactement à la fréquence d'horloge bits fsr.

Néanmoins, le problème qui se pose alors est d'assurer aussi la synchronisation en phase du signal d'horloge fourni par l'oscillateur, par rapport au signal reçu. À ce titre, on sait que le décalage de phase introduit par l'oscillateur est proportionnel à la différence entre la fréquence du signal à l'entrée de l'oscillateur et la fréquence propre fos de ce dernier. En conséquence, on peut penser à ajuster la valeur de la fréquence propre de l'oscillateur en fonction de la fréquence d'horloge bits fsr du signal reçu lors de la conception du circuit. Mais cette solution reste imparfaite dans la mesure où la valeur de cette fréquence d'horloge bits fsr n'est justement pas connue avec précision (ce qui constitue le problème technique initial principal nécessitant la présence d'un circuit d'extraction d'horloge dans le récepteur). En outre, elle nécessiterait en tout état de cause un réglage du circuit pour chaque application. Si un tel réglage est admissible dans le contexte d'un prototype de laboratoire, il n'est pas acceptable dans la plupart des applications industrielles d'un tel circuit. US 6317008 décrit aussi un dispositif d'extraction d'horloge et de données comprenant un oscillateur verrouillé en injection, qui ne comprend pas de boucle d'asservissement en phase et nécessite, comme tous les documents prévoyant l'utilisation d'un tel oscillateur verrouillé en injection, une tension de contrôle de l'oscillateur verrouillé en injection et une calibration individuelle manuelle en fonction de chaque application.

Un certain nombre d'auteurs (cf. par exemple DE 19739645) ont proposé d'adjoindre un asservissement en phase à un oscillateur verrouillé en injection, par une boucle analogique comprenant un comparateur de phase dont la sortie, via un filtre de boucle, permet de contrôler en tension la fréquence propre de l'oscillateur. Néanmoins, les inventeurs ont déterminé que toutes les architectures proposées jusqu'à maintenant présentent deux défauts importants qui en interdisent une exploitation à l'échelle industrielle. Tout d'abord, il s'avère en pratique que chaque circuit doit être réglé individuellement précisément manuellement, notamment en ce qui concerne les différences de délais de propagation entre les différentes voies, à savoir celle transmettant les données et celle permettant d'extraire l'horloge. Une telle calibration individuelle de chaque circuit nécessite la présence d'un réglage manuel externe et est en tout état de cause incompatible avec une exploitation en grande série à l'échelle industrielle. En outre, la plage d'accrochage du circuit est dans tous les cas très faible. En effet, le signal fourni par le générateur d'impulsions alimentant à la fois l'oscillateur et le comparateur de phase n'est pas optimisé pour ces deux circuits simultanément, de sorte qu'un réglage manuel externe de la fréquence propre de l'oscillateur est nécessaire ce qui n'est pas compatible avec une exploitation à l'échelle industrielle. Cela implique aussi qu'il n'est pas possible d'utiliser dans ces boucles d'asservissement en phase connues, un comparateur de phase de réalisation simple, par exemple du type OU exclusif, tout en préservant une plage de capture suffisante et une faible sensibilité aux variations de rapport cyclique des signaux reçus.

FR 2838265 a aussi proposé de résoudre ce problème de décalage de phase en prévoyant une logique de décision pour sélectionner une valeur parmi différentes valeurs fournies par une pluralité de bascules d'échantillonnage décalées selon des durées de décalage distinctes par rapport aux impulsions du signal d'horloge de réception. Il s'avère qu'en pratique cette solution n'est pas réellement efficace dans toutes les situations.

US 3609408 qui a été publié en 1971 décrit un asservissement en phase dans un circuit d'extraction d'horloge fondé sur un circuit résonnant. Il est à noter à cet égard qu'un circuit résonnant doit être distingué d'un oscillateur verrouillé en injection. En particulier, un oscillateur verrouillé en injection produit un signal d'horloge en l'absence de toute transition dans le signal d'entrée, tandis qu'un simple circuit résonnant ne produit pas d'oscillations en permanence et ne produit donc pas de signal d'horloge en l'absence de transition dans le signal d'entrée. Au demeurant, la technologie obsolète de ce document, qui ne peut pas être implémentée en circuit intégré, n'est pas susceptible de remplacer, en termes de performances et de réalisations industrielles, celle d'un oscillateur verrouillé en injection pouvant être réalisé sous forme de circuit intégré. En outre, ce circuit résonnant n'est pas compatible avec des signaux de données en entrée quelconques, notamment lorsque ces derniers présentent des périodes importantes sans transitions. Par exemple, avec le code 8B/10B utilisé très largement dans les réseaux actuels (notamment les réseaux « Gigabit Ethemet »), les circuits d'extraction de d'horloge et de données doivent pouvoir supporter des périodes de 5 bits sans transitions, et avec le code 8B/12B ils doivent supporter des périodes de 11 bits sans transitions. Le dispositif décrit dans ce document n'est pas capable de telles performances. Pour pallier ce problème, compte tenu de l'état de la technique précédemment mentionné, seul un dispositif basé sur une PLL serait envisageable, avec cependant les inconvénients susmentionnés.

Ainsi, malgré d'intensives recherches effectuées depuis longtemps sur ces circuits d'extraction d'horloge et de données, le besoin persiste de pouvoir proposer une solution simple, compatible avec une exploitation en grande série à l'échelle industrielle dans la plupart des applications pratiques actuelles de ces circuits, y compris avec des liaisons à très haut débit -notamment supérieur à 500 Mbits/s- et/ou à très haute fréquence -notamment supérieure à 500 MHz -, dont la consommation énergétique est acceptable, et qui ne nécessite ni réglages externes ni conception spécifique, chaque circuit fabriqué étant nécessairement réglé du fait de sa conception indépendamment de la technologie de réalisation mise en oeuvre.

L'invention vise donc à proposer une telle solution. Les inventeurs ont en effet constaté qu'il était possible, moyennant une architecture spécifique, de proposer pour la première fois un dispositif d'extraction d'horloge et de données qui présente ces qualités, et en particulier qui soit très simple de réalisation, « auto réglé », en présentant une large plage d'accrochage et un taux d'erreurs de bits négligeable.

L'invention vise en particulier à proposer un tel dispositif qui soit compatible avec l'utilisation d'un comparateur de phase de type OU exclusif dans la boucle d'asservissement en phase.

L'invention vise également à proposer un tel dispositif qui soit peu sensible à la variation de qualité des signaux reçus, et en particulier qui soit compatible avec des signaux pouvant présenter une densité de transitions variable et du bruit.

Dans tout le texte, les termes « entrée » et « sortie » d'un composant désignent une borne de connexion ou un ensemble de bornes de connexion recevant ou, respectivement, délivrant un signal. Le signal appliqué sur une entrée ou délivré par une sortie peut donc être, sauf précision complémentaire, aussi bien un signal série qu'un signal parallèle, et peut être constitué d'une seule voie ou de plusieurs voies (notamment dans le cas d'une architecture de type différentiel).

L'invention concerne donc un dispositif d'extraction d'horloge et de données numériques à partir d'un signal série en bande de base, dit signal reçu, représentatif des données numériques et codé avec un signal d'horloge présentant une fréquence d'horloge bits fsr, comprenant :
- un circuit d'extraction d'horloge relié à une entrée, dite entrée de réception, recevant le signal reçu et comprenant :
   - un oscillateur verrouillé en injection comprenant au moins une borne, dite entrée en courant, recevant un signal issu du signal reçu et cadencé à la fréquence d'horloge bits fsr, et délivrant, sur au moins une borne, dite sortie d'horloge, un signal d'horloge, dit signal d'horloge de réception, synchronisé et en phase avec la fréquence d'horloge bits fsr du signal reçu,
   - une boucle d'asservissement en phase comprenant :
      - une première entrée reliée à une sortie d'horloge de l'oscillateur verrouillé en injection,
      - une deuxième entrée alimentée par un signal issu du signal reçu,
      - et une sortie délivrant un signal en tension analogique, dit signal de commande, reliée à une entrée, dite entrée de commande, de l'oscillateur adaptée pour que la valeur de la fréquence propre fos de l'oscillateur dépende de la valeur du signal de commande reçu sur cette entrée de commande, la valeur du signal de commande étant adaptée soit pour être sans effet sur l'oscillateur lorsque la différence de phase entre la première entrée et la deuxième entrée est nulle, soit pour modifier la fréquence propre fos de telle sorte que cette dernière prenne la valeur de la fréquence d'horloge bits fsr du signal d'horloge de réception,
   - un circuit, dit générateur d'impulsions de phase, générant un signal d'impulsions à la fréquence de fronts du signal reçu avec une durée et une amplitude des impulsions adaptées aux caractéristiques de fonctionnement de la boucle d'asservissement en phase, et délivrant ces impulsions sur une seule sortie reliée uniquement à ladite deuxième entrée de la boucle d'asservissement en phase,
   - un circuit générateur d'impulsions en courant générant un signal d'impulsions de courant, à la fréquence de fronts du signal reçu, sur une sortie unique reliée uniquement à l'entrée en courant de l'oscillateur verrouillé en injection,
   - un circuit d'échantillonnage du signal reçu avec le signal d'horloge de réception, ce circuit d'échantillonnage ayant une première entrée, dite entrée de signal, reliée à l'entrée de réception, et une deuxième entrée, dite entrée d'horloge, reliée à au moins une sortie d'horloge de l'oscillateur verrouillé en injection, ce circuit d'échantillonnage étant adapté pour délivrer sur au moins une borne, dite sortie de données, des données numériques transmises par le signal reçu,
   - au moins un circuit déphaseur adapté pour introduire une différence de phase prédéterminée constante entre l'entrée de signal et l'entrée d'horloge du circuit d'échantillonnage, la différence de phase totale entre ces deux entrées résultant de chaque circuit déphaseur étant adaptée pour garantir un alignement en phase du signal à l'entrée de signal et du signal à l'entrée d'horloge.

Le générateur d'impulsions de phase délivrant des impulsions adaptées à la boucle d'asservissement en phase, la plage de capture de cette boucle d'asservissement en phase, et donc du circuit d'extraction d'horloge, est suffisamment importante pour que ce circuit d'extraction d'horloge puisse être exempt de tout réglage manuel extérieur, et notamment de tout réglage de la fréquence d'oscillations libres fos de l'oscillateur verrouillé en injection. Ainsi, le générateur d'impulsions de phase permet de décorréler la boucle d'asservissement en phase vis-à-vis du signal reçu, quelles que soient les caractéristiques de ce dernier (type de codage de la transmission, caractéristiques électriques et temporelles). En particulier, les impulsions délivrée par le générateur d'impulsions de phase permet de s'affranchir de la forme d'onde réelle du signal reçu en évitant tout bruit d'amplitude, et en redressant les fronts montants et descendants. En outre, ces impulsions sont calibrées en durée et en amplitude de façon à être particulièrement optimisées et adaptées à la boucle d'asservissement en phase, notamment au comparateur de phase contenu dans cette boucle. En particulier, ces impulsions sont des impulsions en tension et peuvent être calibrées pour présenter un rapport cyclique spécifique prédéterminé et/ou un niveau d'amplitude spécifique prédéterminé. Cette calibration en durée et en amplitude réalisée au sein même du dispositif selon l'invention, permet de contrôler la gamme de fréquence du signal reçu sur laquelle l'asservissement en phase pourra se réaliser, et ainsi d'obtenir une plage de capture beaucoup plus élevée qu'avec les dispositifs de l'état de la technique antérieur. Ainsi, il n'est plus nécessaire, comme dans l'état de la technique (cf. par exemple bornes de commande 13, 13', 26, 26' de DE 19739645), de prévoir un réglage visant à aligner approximativement la fréquence d'oscillations libres fos de l'oscillateur sur la fréquence nominale fn de fonctionnement du dispositif, ou même sur la fréquence d'horloge bits fsr du signal reçu. Ainsi, un dispositif selon l'invention est capable de s'adapter en temps réel (c'est-à-dire avec une latence très faible de quelques bits dans la pire situation et en général inférieure à une durée de bit) aux évolutions de la fréquence du signal reçu sur une large gamme de fréquences.

L'invention permet ainsi d'apporter des avantages décisifs dans la conception des dispositifs d'extraction d'horloge et de données numériques, en permettant une exploitation à l'échelle industrielle d'un circuit dont le fonctionnement est basé sur un oscillateur verrouillé en injection.

Un dispositif selon l'invention est, du fait de son architecture globale, complètement autonome, c'est-à-dire ne nécessite aucun réglage externe manuel ou autre, ni aucune calibration. Ainsi, un dispositif selon l'invention est exempt de tout moyen de réglage manuel externe. De surcroît, cette autonomie est obtenue avec une grande simplicité de réalisation.

Dans un dispositif selon l'invention il est possible d'utiliser un comparateur de phase extrêmement simple, par exemple de type OU exclusif, de consommation réduite et autorisant une montée en fréquence, la boucle d'asservissement en phase présentant une plage de capture suffisamment étendue pour qu'aucun réglage extérieur ne soit nécessaire. Un dispositif selon l'invention ne nécessite pas non plus la présence d'une référence de fréquence externe, et ce contrairement à une PLL traditionnelle. En outre, avec un dispositif selon l'invention, le préambule de synchronisation au démarrage peut être réduit considérablement, en général à quelques bits. Du fait de sa très grande simplicité, l'architecture d'un dispositif selon l'invention permet sa réalisation avec un très faible nombre de composants élémentaires à faible consommation d'énergie (donc une surface réduite et une consommation plus faible). Un dispositif selon l'invention peut également être conçu sans nécessiter l'intervention d'un concepteur possédant un grand savoir-faire en matière de conception de circuits extracteurs d'horloge et de données (contrairement aux dispositifs antérieurs à base de PLL dans lesquels il est en particulier très difficile de réaliser un comparateur phase/fréquence fonctionnant à haute fréquence). Il est aussi possible, avec un dispositif conforme à l'invention de conception simple, d'atteindre des vitesses de transmission proches des limites offertes par la technologie des semi-conducteurs. Il est en particulier possible d'atteindre des vitesses de transmission sensiblement plus élevées qu'avec les circuits antérieurs à base de PLL ou de DLL. En outre, il est possible de réaliser un dispositif selon l'invention avec une technologie semi-conducteur quelconque (CMOS, bipolaire, SiGe,...).

Contrairement à un circuit à base de DLL, le taux d'erreurs de bit d'un dispositif selon l'invention est moins sensible aux bruits sur le signal reçu, et le codage des données présente un taux d'expansion similaire à celui d'une PLL traditionnelle, c'est-à-dire bien inférieur à celui requis par une DLL.

Il est en outre à noter que les inventeurs ont pu démontrer qu'un dispositif selon l'invention est intrinsèquement très peu sensible aux événements transitoires pouvant être déclenchés par des particules ionisantes une fois que l'oscillateur est en mode verrouillé. Ainsi, un dispositif selon l'invention est particulièrement avantageux pour les applications nucléaires, aéronautiques, militaires et spatiales. Cela étant, un dispositif selon l'invention étant peu sensible, au niveau du sol, aux neutrons atmosphériques, aux particules alpha et aux bruits parasites intrinsèques aux technologies submicroniques, est également particulièrement avantageux dans les autres applications industrielles dans lesquelles ces phénomènes sont présents.

Par ailleurs, compte tenu de la simplicité et de l'efficacité de la boucle d'asservissement en phase, dans un dispositif selon l'invention, la fréquence propre fos de l'oscillateur est toujours égale à la fréquence d'horloge bits fsr du signal d'horloge de réception, et l'écart de phase entre le signal d'horloge délivré par l'oscillateur et le signal reçu est fixe. Or, l'ensemble des autres éléments constitutifs du dispositif pouvant entraîner un déphasage constant entre les deux entrées du circuit d'échantillonnage, il est possible de déterminer le retard différentiel de phase structurel constant entre ces deux entrées du circuit d'échantillonnage. Dès lors, il suffit de prévoir un (ou plusieurs) circuit(s) déphaseur(s) pour garantir un alignement en phase entre les deux entrées du circuit d'échantillonnage, sans nécessiter aucun réglage extérieur, pour que le dispositif selon l'invention puisse fonctionner de façon autonome et stable avec une large plage de capture. Il est à noter à cet égard que ce (ces) circuit(s) déphaseur(s) est (sont) prévu(s) en supplément à l'éventuel circuit déphaseur parfois nécessairement prévu à l'entrée d'un circuit tel qu'un comparateur de phase, pour compenser les déphasages introduits par certaines architectures de ce type de circuit (cf. par exemple GB 2113929 qui prévoit un circuit retard permettant d'assurer que le signal de sortie du comparateur de phase est bien égal à zéro lorsque les signaux à l'entrée sont en phase). Un tel circuit déphaseur nécessaire au fonctionnement d'un comparateur de phase qu'il alimente, est fonctionnellement différent du (des) circuit(s) déphaseur(s) d'un dispositif selon l'invention, dont la fonction est d'introduire un déphasage supplémentaire pour compenser le déphasage total entre les deux entrées du circuit d'échantillonnage.

Ainsi, l'invention permet d'obtenir, pour la première fois, un circuit d'extraction de données et d'horloge parfaitement autonome et stable, pouvant faire l'objet d'une exploitation à l'échelle industrielle dans de nombreuses applications.

Avantageusement et selon l'invention, la boucle d'asservissement en phase comprend un circuit comparateur de phase comprenant une première entrée reliée à la sortie d'horloge, une deuxième entrée reliée à la sortie du générateur d'impulsions de phase, et une sortie délivrant un signal -notamment un signal en tension- analogique dont l'amplitude est fonction de la différence de phase entre la première entrée et la deuxième entrée, et en ce que le générateur d'impulsions de phase est adapté pour générer un signal d'impulsions avec une durée et une amplitude des impulsions adaptées aux caractéristiques de fonctionnement de ce comparateur de phase.

Dans un dispositif selon l'invention, il est possible d'utiliser un comparateur de phase choisi de façon optimale par rapport à l'application envisagée. En particulier, le choix du comparateur de phase ne dépend plus de son comportement supposé par rapport au signal reçu et aux données contenues dans ce signal reçu. Il est donc possible de choisir ce comparateur de phase en fonction de ses performances intrinsèques (facilité de conception et d'implémentation, consommation d'énergie,...). En particulier, il est possible d'utiliser un comparateur de phase extrêmement simple du point de vue de sa réalisation technologique, et qui en pratique présente une réponse dynamique améliorée (et donc autorisent des fréquences de transmission plus élevée), minimise la durée de conception du circuit, peut être utilisé facilement dans toute technologie de réalisation et présente une faible consommation d'énergie. Les circuits comparateurs de phase les plus simples nécessitant un signal d'entrée en tension, avantageusement et selon l'invention, ledit générateur d'impulsions de phase est adapté pour délivrer un signal d'impulsions en tension.

Par ailleurs, dans un dispositif selon l'invention, le générateur d'impulsions de phase est adapté pour délivrer des impulsions ayant une amplitude adaptée au comparateur de phase (définissant des états logiques haut ou bas), et dont la largeur est égale à la moitié de la durée nominale d'un bit du signal reçu (la moitié de l'inverse de la fréquence nominale fn d'horloge bits des données du signal reçu).

En outre, avantageusement et selon l'invention, le comparateur de phase est formé d'une porte OU exclusif. Grâce à l'invention, et du fait que le générateur d'impulsions de phase fournit un signal d'impulsions en tension adaptées précisément au comparateur de phase, il est en effet possible, pour la première fois, d'envisager l'utilisation d'un tel comparateur de phase extrêmement simple, malgré les très nombreux défauts (notamment faible plage de capture, grande sensibilité au rapport cyclique des signaux d'entrée, ondulation du signal de sortie à erreur de phase nulle ...) de ce type de comparateur de phase, qui dissuadaient jusqu'à maintenant d'en faire l'utilisation dans des dispositifs d'extraction d'horloge et de données performants.

Par ailleurs, avantageusement et selon l'invention, ladite sortie du comparateur de phase est reliée à l'entrée d'un filtre de boucle, ce filtre de boucle comprenant une sortie délivrant le dit signal de commande. Un tel filtre de boucle génère une tension moyenne du signal fourni par le circuit comparateur de phase et permet de filtrer les composantes à haute fréquence de la différence de phase entre le signal reçu et le signal d'horloge de réception.

En outre, le circuit d'extraction d'horloge comprend en outre un circuit générateur d'impulsions en courant, dit générateur d'impulsions de synchronisation, distinct dudit générateur d'impulsions de phase, et générant un signal d'impulsions de courant, à la fréquence de fronts du signal reçu, et adapté au fonctionnement de l'oscillateur verrouillé en injection, ce générateur d'impulsions de synchronisation générant le dit signal d'impulsions de courant sur une sortie unique reliée uniquement à l'entrée en courant de l'oscillateur verrouillé en injection. Les impulsions en courant délivrées par ce générateur d'impulsions de synchronisation sont adaptées à l'entrée de l'oscillateur verrouillé en injection de façon à assurer son fonctionnement, c'est-à-dire le verrouillage de l'oscillateur sur la fréquence d'horloge bits fsr. En particulier, dans un dispositif selon l'invention, les impulsions fournies à l'entrée de l'oscillateur ne sont pas les mêmes que celles fournies à l'entrée de la boucle d'asservissement en phase. Ce découplage des impulsions permet en pratique d'optimiser le fonctionnement de chaque composant et d'éviter tout réglage extérieur comme indiqué ci-dessus.

Par ailleurs, tout type d'oscillateur verrouillé en injection peut être utilisé dans le cadre de l'invention. Il peut s'agir en particulier d'un oscillateur à relaxation de type RC ou à source de courant, d'un oscillateur astable à portes logiques ou émetteurs couplés, d'un oscillateur en anneau, d'un oscillateur quasi-sinusoïdal à pont de Wien, déphasage ou LC, d'un oscillateur Colpitts, Hartley, Clapp, Pierce ou à résistance négative à circuit résonant LC, à lignes de transmission ou résonateur de type quartz, résonateur à ondes de surface, à MEMS ou piézo-électrique intégré,... Néanmoins, avantageusement et selon l'invention, l'oscillateur verrouillé en injection est du type formé d'un circuit résonnant LC. Un tel oscillateur présente en particulier l'avantage de minimiser la dérive de phase (« jitter ») intrinsèque. Plus particulièrement, avantageusement et selon l'invention l'oscillateur verrouillé en injection comprend deux branches comprenant chacune un transistor à effet de champ à résistance négative, les deux transistors étant couplés selon une topologie différentielle. Il peut s'agir d'un oscillateur tel que décrit dans FR 2838265. Plus généralement, un dispositif sur l'invention est avantageusement réalisé selon une architecture différentielle, et est donc adapté à recevoir un signal reçu de type différentiel.

Avantageusement un dispositif selon l'invention est réalisé sous forme d'au moins un circuit intégré incorporant au moins l'oscillateur verrouillé en injection. Un dispositif d'extraction d'horloge et de données numériques selon l'invention est adapté pour pouvoir fonctionner avec une fréquence d'horloge bits fsr supérieure à 500 MHz.

L'invention concerne également un dispositif d'extraction d'horloge et de données numériques caractérisé en combinaison par tout ou partie des caractéristiques mentionnées ci-dessus ou ci-après.

D'autres buts, caractéristiques et avantages de l'invention apparaîtront à la lecture de la description suivante donnée à titre non limitatif et qui se réfère aux figures annexées dans lesquelles :
- la figure 1 est un schéma synoptique fonctionnel général illustrant un dispositif d'extraction d'horloge et de données numériques conforme à un premier mode de réalisation de l'invention,
- la figure 2 est un schéma synoptique d'un mode de réalisation du générateur d'impulsions de phase et du comparateur de phase du dispositif de la figure 1,
- la figure 3 est un schéma d'un exemple de réalisation d'un circuit tampon du générateur d'impulsions de la figure 2,
- la figure 4 est un schéma d'un exemple de réalisation d'un élément de circuit retard du générateur d'impulsions de la figure 2,
- la figure 5 est un schéma d'un exemple de réalisation d'une porte XOR constituant le générateur d'impulsions de la figure 2,
- la figure 6 est un schéma d'un exemple de réalisation du comparateur de phase du dispositif de la figure 1,
- la figure 7 est un chronogramme illustrant respectivement la forme du signal de données reçu, des impulsions délivrées par le générateur d'impulsions de phase de la figure 2, et par le générateur d'impulsions de synchronisation alimentant l'oscillateur du dispositif de la figure 1,

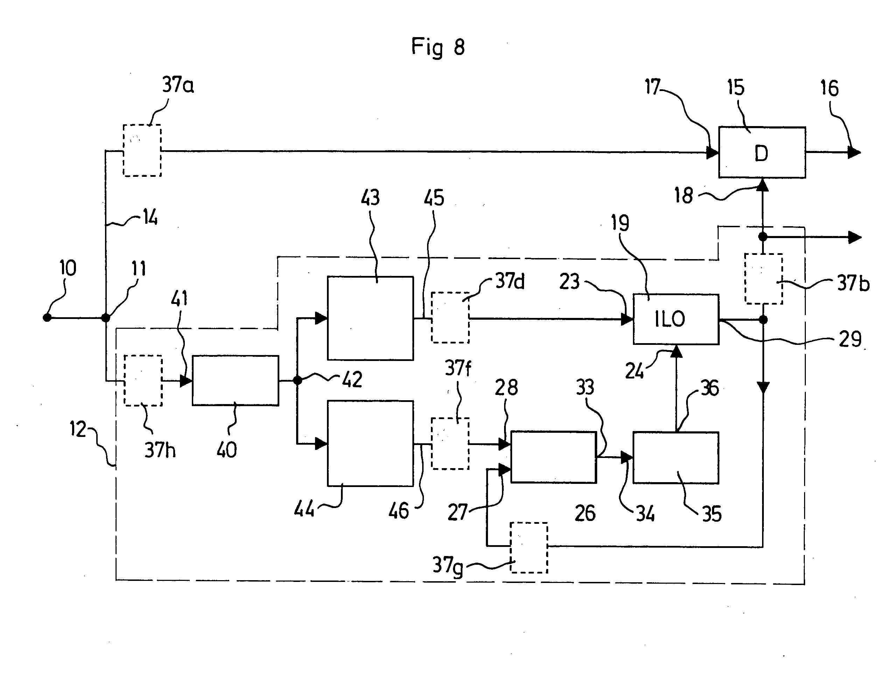

- la figure 8 est un schéma synoptique fonctionnel général illustrant un dispositif d'extraction d'horloge et de données numériques conforme à un deuxième mode de réalisation de l'invention,
- la figure 9 est un schéma d'un exemple de réalisation d'un étage d'adaptation du générateur d'impulsion délivrant des impulsions en tension pour le circuit comparateur de phase du dispositif de la figure 8,
- la figure 10 est un schéma d'un exemple de réalisation d'un étage d'adaptation du générateur d'impulsions délivrant des impulsions en courant de synchronisation pour l'oscillateur du dispositif de la figure 8,
- la figure 11 est un schéma illustrant un mode de réalisation d'un oscillateur verrouillé en injection pouvant être utilisé dans un dispositif d'extraction conforme à l'invention,
- la figure 12 est un schéma illustrant un exemple de forme d'un signal reçu bruité.

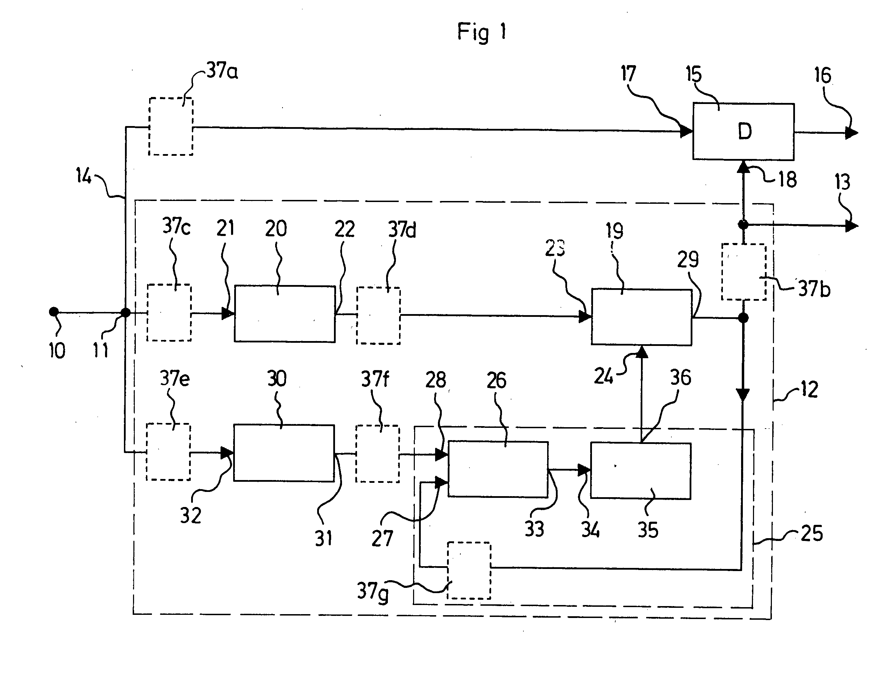

Le dispositif d'extraction d'horloge et de données numériques conforme à l'invention représenté sur la figure 1 reçoit sur une entrée principale, dite entrée de réception 10, un signal, dit signal reçu, qui est un signal série en bande de base représentatif de données numériques et est codé avec un signal d'horloge présentant une fréquence d'horloge bits fsr. En général ce signal est un signal codé du type NRZ (« non return to zéro ») reçu sur un canal de transmission d'une liaison série en bande de base. Ce canal de transmission peut être formé d'un fil conducteur électrique unique, ou d'une fibre optique unique, ou d'une liaison radio fréquence monocanal (signal non différentiel). L'invention est néanmoins applicable également dans le cas d'un signal reçu du type transmis en différentiel, le canal de transmission comprenant alors deux lignes transmettant deux composantes en opposition de phase. L'invention est aussi applicable à d'autres types de codage du signal reçu, par exemple NRZI (« non retum to zéro inverted»).

L'entrée de réception 10 est reliée à un noeud de dérivation 11 auquel sont reliées deux branches en parallèle, à savoir une première branche d'extraction d'horloge 12 générant sur une sortie d'horloge 13 un signal d'horloge, dit signal d'horloge de réception, synchronisé et en phase avec la fréquence d'horloge bits fsr du signal reçu, et une autre branche 14 comprenant un circuit d'échantillonnage 15 du signal reçu avec le signal d'horloge de réception, ce circuit d'échantillonnage 15 étant apte à délivrer, sur une sortie de données 16, des données numériques transmises dans le signal reçu.

Le circuit d'extraction d'horloge 12 comprend un oscillateur verrouillé en injection 19 alimenté par un générateur d'impulsions en courant, dit générateur d'impulsions de synchronisation 20, ce dernier présentant une entrée 21 reliée au noeud 11 de l'entrée de réception 10. Le générateur d'impulsions de synchronisation 20 présente une sortie unique 22 (qui peut être formée par deux lignes dans le cas d'une topologie différentielle) reliée uniquement à l'entrée en courant 23 de l'oscillateur verrouillé en injection 19. Le signal d'impulsions de courant fourni par le générateur d'impulsions de synchronisation 20 est adapté au fonctionnement de l'oscillateur verrouillé en injection 19 et est cadencé à la fréquence de fronts du signal reçu. L'ensemble peut être réalisé par exemple comme décrit par FR 2838265. En particulier, l'oscillateur verrouillé en injection 19 est alors du type formé d'un circuit résonnant LC symétrique définissant la fréquence d'oscillations libres fos d'oscillation, et doté de deux branches croisées comprenant chacune un transistor à effet de champ à résistance négative, les deux transistors étant ainsi couplés selon une topologie différentielle. L'oscillateur verrouillé en injection 19 présente une sortie d'horloge 29 délivrant un signal d'horloge synchronisé et en phase avec la fréquence d'horloge bits du signal reçu.

Le circuit d'échantillonnage 15 comprend une première entrée, dite entrée de signal 17, reliée par la deuxième branche 14 à l'entrée de réception 10, et une deuxième entrée, dite entrée d'horloge 18, reliée à la sortie d'horloge du circuit d'extraction d'horloge 12, c'est-à-dire à la sortie d'horloge 29 de l'oscillateur 19. Ce circuit d'échantillonnage 15 peut être formé d'une simple bascule D.

L'oscillateur verrouillé en injection 19 comprend par ailleurs une entrée, dite entrée de commande 24 adaptée pour que la valeur de la fréquence propre fos de l'oscillateur dépende de la valeur du signal de commande reçu sur cette entrée de commande 24.

Le circuit d'extraction d'horloge 12 du dispositif selon l'invention comprend une boucle d'asservissement en phase 25 présentant un fonctionnement de type analogique. Cette boucle d'asservissement en phase 25 comprend un comparateur de phase 26 présentant deux entrées 27, 28. La première entrée 27 du comparateur de phase 26 est reliée à la sortie d'horloge 29 de l'oscillateur 19 de façon à recevoir le signal d'horloge de réception formé par l'oscillateur 19 sur cette sortie 29. La deuxième entrée 28 est reliée à la sortie 31 d'un circuit générateur d'impulsions, dit générateur d'impulsions de phase 30, dont l'entrée 32 est reliée via le noeud de dérivation 11 à l'entrée de réception 10. Ainsi, le signal reçu est délivré à l'entrée du générateur d'impulsions de phase 30, et ce dernier présente une sortie unique 31 (qui peut être formée par deux lignes dans le cas d'une réalisation sous forme d'une topologie différentielle) qui est reliée à la deuxième entrée 28 du comparateur de phase 26.

Le circuit générateur d'impulsions de phase 30 est distinct du générateur d'impulsions de synchronisation 20. De la sorte, ces deux circuits générateurs d'impulsions 20, 30 peuvent présenter des caractéristiques différentes, adaptées précisément indépendamment les unes des autres.

Le circuit générateur d'impulsions de phase 30 est adapté pour générer un signal d'impulsions à la fréquence de fronts du signal reçu, c'est-à-dire au maximum à la fréquence d'horloge bits fsr.

Il est à noter à cet égard que si le signal reçu était directement utilisé pour alimenter le comparateur de phase, l'asservissement en phase pourrait être au mieux cadencé à la moitié de la fréquence des fronts du signal reçu, c'est-à-dire au maximum à fsr/2. En effet, un signal de données pseudo-aléatoire cadencé à une fréquence d'horloge bits fsr présente un spectre de fréquences ayant des maximums aux harmoniques impaires (fsr/2, 3fsr/2,...) de la fréquence fsr/2 et des minimums aux harmoniques paires (2fsr/2, 4fsr/2,...) de la fréquence fsr/2. Ainsi, dans un dispositif selon l'invention, le circuit générateur d'impulsions de phase 30 permet de cadencer l'asservissement en phase à une fréquence correspondant à celle des fronts du signal reçu. Ces impulsions sont cadencées sur les fronts montants et sur les fronts descendants. La durée et l'amplitude des impulsions sont précisément adaptées aux caractéristiques de fonctionnement du comparateur de phase 26, de façon à assurer une large plage de fonctionnement de ce dernier.

Le signal d'impulsions délivré par le générateur d'impulsions de phase 30 est un signal d'impulsions -notamment un signal en tension- ayant une amplitude adaptée au comparateur de phase 26, définissant des états logiques haut (tension Vmax) ou bas (tension Vmin). La largeur des impulsions délivrées par le générateur d'impulsions de phase 30 est égale à la moitié de la durée nominale d'un bit du signal reçu (la moitié de l'inverse de la fréquence nominale fn d'horloge bits du signal reçu). Comme indiqué ci-dessus, les données codées dans le signal reçu ne présentent pas d'énergie à la fréquence d'horloge bits fsr. En l'absence d'un tel générateur d'impulsions de phase 30, la plage de capture serait très faible.

Dans le mode de réalisation représenté et de préférence, le comparateur de phase 26 est formé d'une simple porte OU exclusif (XOR). D'autres modes de réalisation sont possibles (par exemple générateur harmonique, redresseur de fronts, détecteur de fronts, détecteur de passage par zéro, doubleur de fréquence, etc.). Néanmoins, c'est un avantage de l'invention que de permettre l'utilisation d'une simple porte OU exclusif à titre de comparateur de phase 26.

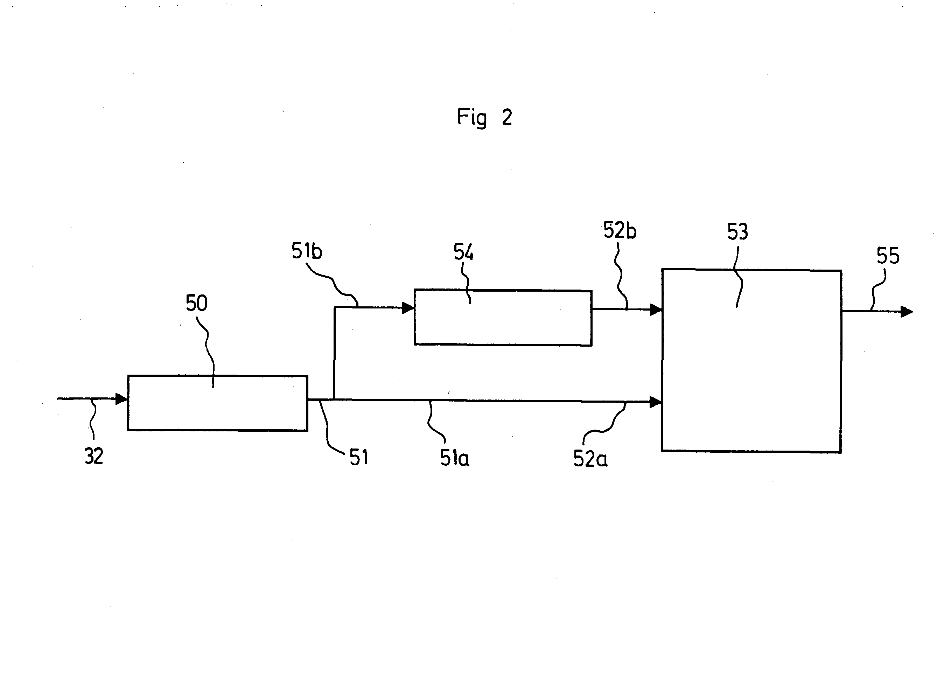

Le générateur d'impulsions de phase 30 peut être réalisé par tout circuit apte à délivrer des impulsions appropriées. La figure 2 est un schéma d'un exemple de réalisation possible, comprenant un circuit tampon 50 recevant le signal de données sur son entrée 32 qui forme l'entrée du générateur d'impulsions de phase 30, la sortie 51 de ce circuit tampon 50 étant scindée en deux branches 51a et, respectivement, 51b, dont l'une, 51a est directement reliée à une première entrée 52a d'une porte OU exclusif (XOR) 53, et l'autre 51b comprend un circuit retard 54 dont la sortie est reliée à une deuxième entrée 52b de la porte OU exclusif 53. La porte OU exclusif 53 présente une sortie 55 délivrant un signal en tension.

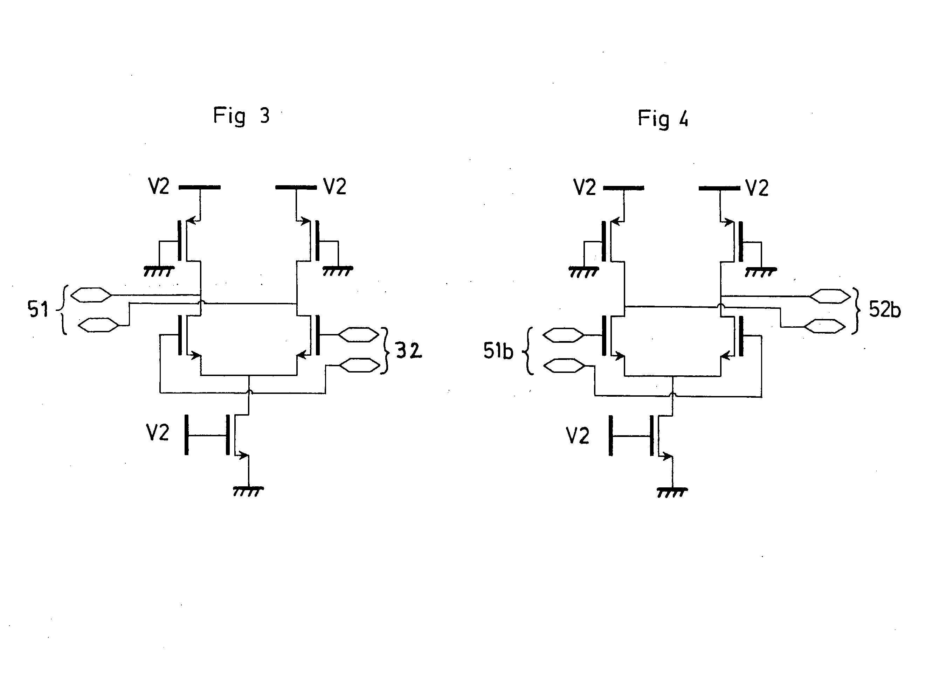

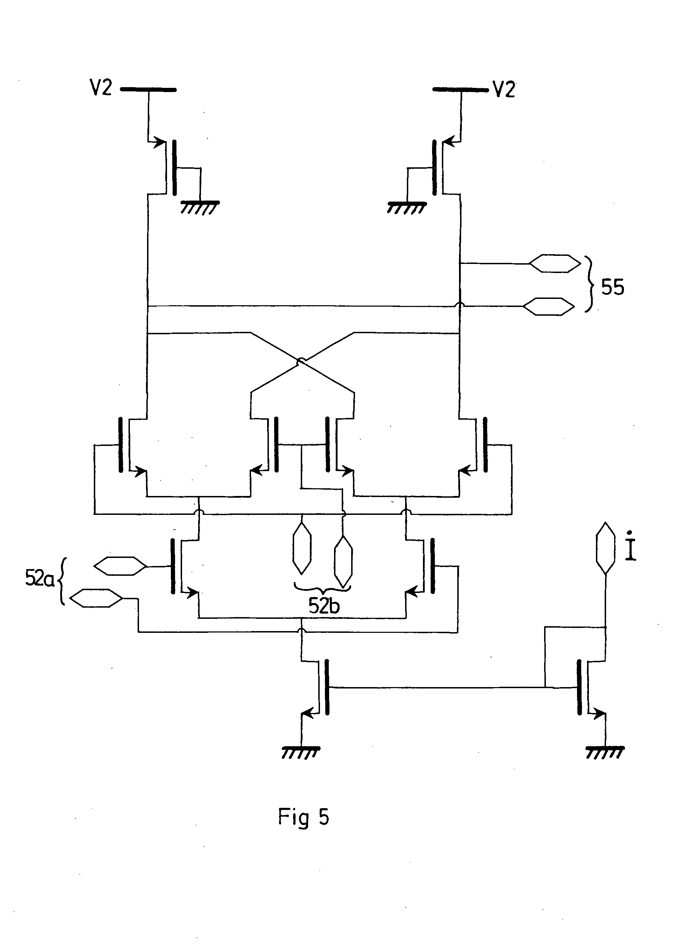

La figure 3 est un exemple de circuit électronique pouvant faire office de circuit tampon 50 réalisé avec une architecture différentielle (les données reçues et tous les signaux étant transmis sur deux voies complémentaires en opposition de phase). La figure 4 est un exemple de circuit électronique, avec une architecture différentielle, pouvant faire office d'un élément de retard du circuit retard 54, ce dernier comportant une pluralité de tels éléments en série dont le nombre est adapté pour déterminer la largeur des impulsions à former. La figure 5 est un exemple de circuit électronique avec une architecture différentielle pouvant être utilisé pour réaliser la porte OU exclusif 53.

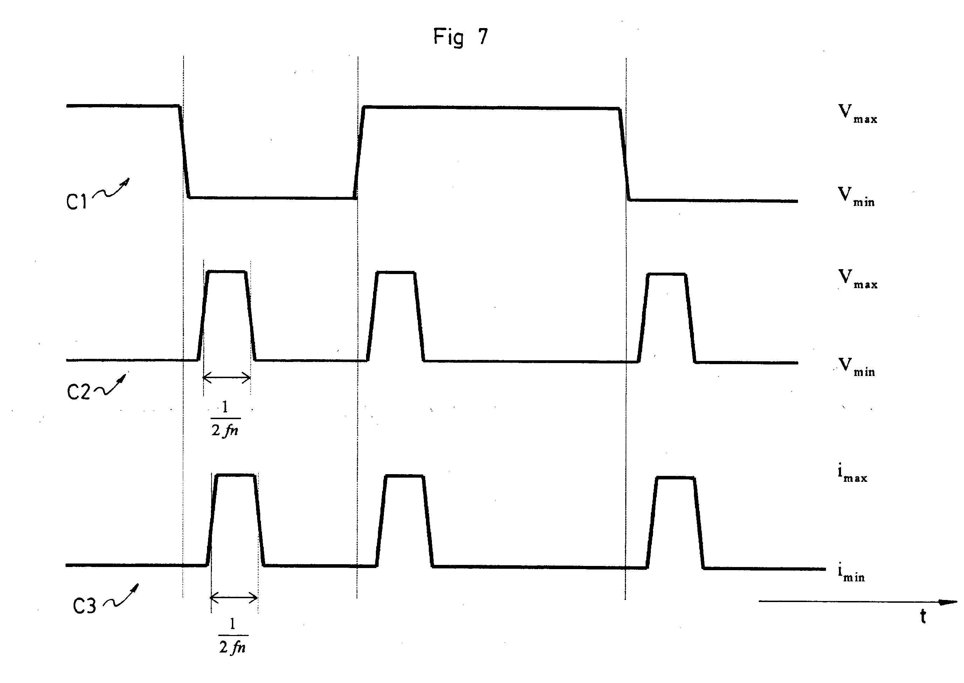

La figure 7 est un chronogramme illustrant un exemple de signal reçu (courbe C1), la forme correspondante des impulsions en tension générées par le générateur d'impulsions de phase 30 (courbe C2), et la forme correspondante des impulsions en courant générées par le générateur d'impulsions de synchronisation 20 (courbe C3).

Le comparateur de phase 26 présente une sortie 33 sur laquelle il délivre un signal d'amplitude proportionnelle au décalage de phase entre ses deux entrées 27, 28, c'est-à-dire à la différence de phase entre le signal reçu (les impulsions délivrées par le générateur d'impulsions de phase 30 étant en phase avec les fronts du signal reçu) et le signal d'horloge de réception fourni par l'oscillateur 19. En particulier lorsque les signaux sur ses deux entrées 27, 28 sont en phase, le signal délivré sur la sortie 33 du comparateur de phase 26 est à une valeur de repos qui est adaptée pour être sans effet sur l'oscillateur 19. Cette valeur de repos peut être une valeur nulle ou une autre valeur, selon les caractéristiques de l'entrée de commande 24 de l'oscillateur 19.

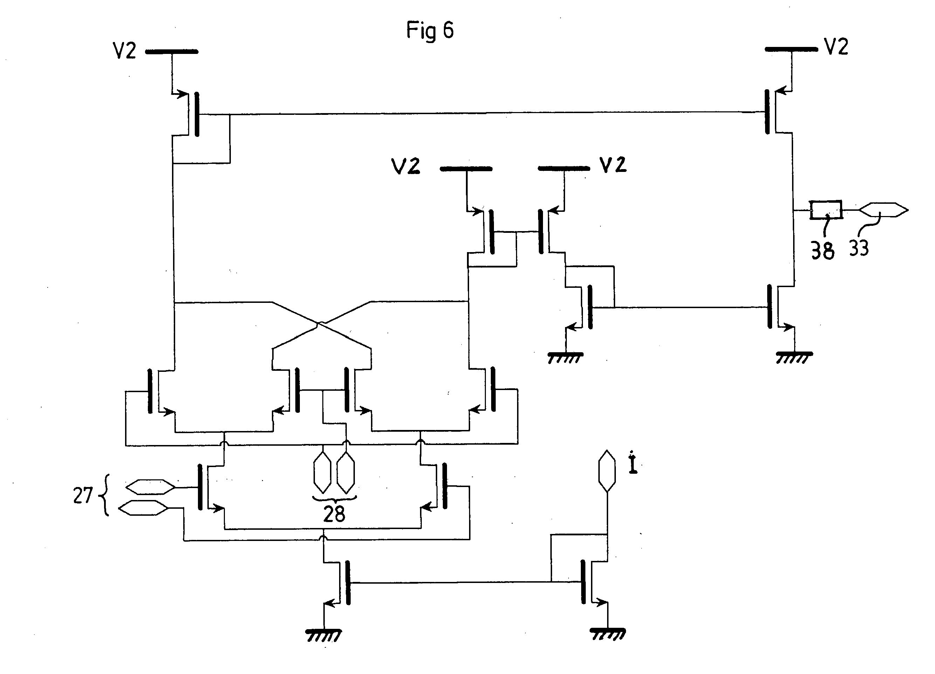

La figure 6 est un exemple de circuit électronique avec une architecture différentielle pouvant être utilisé pour réaliser le comparateur de phase 26 sous forme d'une porte OU exclusif ayant une borne de sortie unique délivrant un signal en courant et formant via une impédance de sortie 38, la sortie 33 en tension du comparateur de phase 26.

En réalité, ce circuit est un multiplicateur. L'amplitude des impulsions délivrées par le générateur d'impulsions de phase 30 est suffisamment importante pour que ce multiplicateur fonctionne hors de sa zone linéaire, le courant de sortie ne dépendant pas de l'amplitude des tensions d'entrées, mais seulement de leurs phases. Ce multiplicateur est donc équivalent à une porte OU exclusif et son gain en comparaison de phase est maximal, ainsi que la bande passante de la boucle d'asservissement de phase 25, et donc la plage de capture du dispositif selon l'invention.

Par ailleurs, il est à noter qu'en variante non représentée, tout ou partie de l'impédance de sortie 38 du comparateur de phase 26 peut être intégrée à l'entrée 34 du filtre de boucle 35.

Sur tous les exemples de circuits électroniques représentés sur les figures 3 à 6, V1 et V2 sont des tensions de polarisation, I est un courant de polarisation.

La sortie 33 du comparateur de phase 26 est reliée à l'entrée 34 d'un filtre de boucle 35 générant une tension moyenne du signal fourni par le comparateur de phase 26 et permettant de filtrer les variations à haute fréquence de la différence de phase entre le signal reçu et le signal d'horloge de réception. La sortie 36 du filtre de boucle 35 est reliée à l'entrée de commande 24 de l'oscillateur 19, de sorte que la fréquence propre fos est asservie sur la différence de phase entre le signal reçu et le signal d'horloge de réception. Lorsque ces signaux sont en phase, la fréquence propre fos de l'oscillateur est égale à la fréquence d'horloge bits fsr du signal reçu. Si un décalage de phase apparaît, la boucle d'asservissement en phase 25 ainsi formée permet de modifier la valeur de la fréquence propre fos de l'oscillateur pour rattraper le décalage de phase.

Du fait de la présence du générateur d'impulsions de phase 30 spécifique pour alimenter le comparateur de phase 26, ce dernier peut être extrêmement simple sans affecter la plage de capture de la boucle de phase 25. Aucun réglage externe manuel n'est nécessaire notamment en ce qui concerne la fréquence propre fos de l'oscillateur 19. En outre, quel que soit le signal reçu, la boucle d'asservissement en phase 25 permet d'assurer que le signal d'horloge de réception fourni par l'oscillateur 19 soit toujours en phase avec le signal reçu.

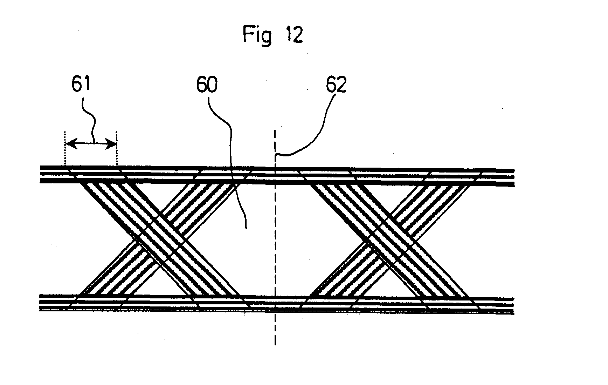

Dans ces conditions, dans un dispositif selon l'invention, les décalages de phase dus aux délais de propagation dans les différentes branches du circuit sont tous connus et constants et peuvent donc être compensés par un (ou plusieurs) circuit(s) déphaseur(s) 37 placé(s) entre le noeud de dérivation 11 et chacune des entrées 17, 18 du circuit d'échantillonnage 15. Il est en effet important que le circuit d'échantillonnage 15 réalise un échantillonnage du signal reçu dans la zone centrale de la période de chaque bit de donnée du signal reçu où la valeur de la tension correspondante est la plus stable et où la marge de bruit est la plus grande, et ce afin d'éviter de réaliser l'échantillonnage sur le début ou la fin de la période de chaque bit où la tension du signal, en cours d'établissement, est soumise à une dérive de phase (traditionnellement désignée « jitter ») comme représenté sur la figure 12. La figure 12 représente en effet l'allure réelle d'un signal reçu, généralement bruité, chaque bit se présentant sous forme d'un « oeil » compte tenu de la dérive de phase (« jitter ») 61. L'échantillonnage doit se produire idéalement au centre de l'oeil 60, c'est-à-dire à l'instant représenté par la ligne 62.

Or, la différence entre la fréquence d'horloge bits fsr des bits reçus et la fréquence d'oscillation fos de l'oscillateur 19 étant nulle dans un dispositif selon l'invention, et l'ensemble des retards pouvant être introduits par les autres composants du circuit et l'ensemble des délais de propagation dans les différentes branches du circuit étant maîtrisés et connus, il est possible de déterminer le retard différentiel de phase structurel et constant entre les données contenues dans le signal reçu et le signal d'horloge de réception délivrée par l'oscillateur 19. Ce retard différentiel est compensé par le (les) circuit(s) déphaseur(s) 37.

Un seul circuit déphaseur 37 peut être prévu dans le dispositif selon l'invention, à tout endroit approprié. En variante, le déphasage entre les deux branches 12, 14 peut être obtenu par une pluralité de circuits déphaseurs 37 répartis en plusieurs endroits de chaque branche. Dans ce dernier cas, le cumul des déphasages introduits par chaque circuit déphaseur 37 est égal au déphasage total qui doit être réalisé entre les deux branches 12, 14.

Sur la figure 1 sont représentés en pointillés différents emplacements possibles auxquels un circuit déphaseur 37 peut être prévu. Ainsi, on peut prévoir un circuit déphaseur 37a entre le noeud de dérivation 11 et l'entrée de signal 17 du circuit d'échantillonnage 15 ; un circuit déphaseur 37b entre la sortie 29 de l'oscillateur 19 et l'entrée d'horloge 18 du circuit d'échantillonnage 15 ; un circuit déphaseur 37c entre le noeud de dérivation 11 et l'entrée 21 du générateur d'impulsions 20 alimentant l'oscillateur 19 ; un circuit déphaseur 37d entre la sortie 22 du générateur d'impulsions 20 et l'entrée 23 de l'oscillateur 19 ; un circuit déphaseur 37e entre le noeud de dérivation 11 et l'entrée 32 du générateur d'impulsions de phase 30 ; un circuit déphaseur 37f entre la sortie 31 du générateur d'impulsions de phase 30 et la deuxième entrée 28 du comparateur de phase 26 ; un circuit déphaseur 37g entre la sortie 29 de l'oscillateur 19 et la première entrée 27 du comparateur de phase 26. Chaque circuit déphaseur 37 peut être formé d'une simple ligne retard.

Le mode de réalisation représenté figure 4 diffère de celui de la figure 1 uniquement par le fait que les deux générateurs d'impulsions 20, 30 sont remplacés par un seul générateur d'impulsions 40 alimentant en impulsions deux étages d'adaptation 43, respectivement 44, différents reliés en parallèle à la sortie 42 du générateur d'impulsions 40. L'entrée 41 du générateur d'impulsions 40 est reliée au noeud de dérivation 11 pour recevoir le signal reçu, le cas échéant par l'intermédiaire d'un circuit déphaseur 37h. Le premier étage d'adaptation 43 délivre, comme le générateur d'impulsions de synchronisation 20 du mode de réalisation de la figure 1, des impulsions en courant sur sa sortie 45 reliée à l'entrée en courant 23 de l'oscillateur 19, éventuellement par l'intermédiaire du circuit déphaseur 37d. Le deuxième étage d'adaptation 44 délivre, comme le générateur d'impulsions de phase 30 du mode de réalisation de la figure 1, des impulsions -notamment en tension- sur sa sortie 46 reliée à la deuxième entrée 28 du comparateur de phase 26, éventuellement par l'intermédiaire du circuit déphaseur 37f. Ainsi, le générateur d'impulsions 40 et le premier étage d'adaptation 43 constituent ensemble un circuit générateur d'impulsions de synchronisation en courant. De même, le générateur d'impulsions 40 et le deuxième étage adaptation 44 constituent ensemble un circuit générateur d'impulsions de phase générant sur sa sortie 46 des impulsions adaptées au comparateur de phase 26. En conséquence, là encore, le dispositif selon l'invention comprend deux générateurs d'impulsions distincts, à savoir un générateur d'impulsions de phase 40, 44, et un générateur d'impulsions de synchronisation 40, 43.

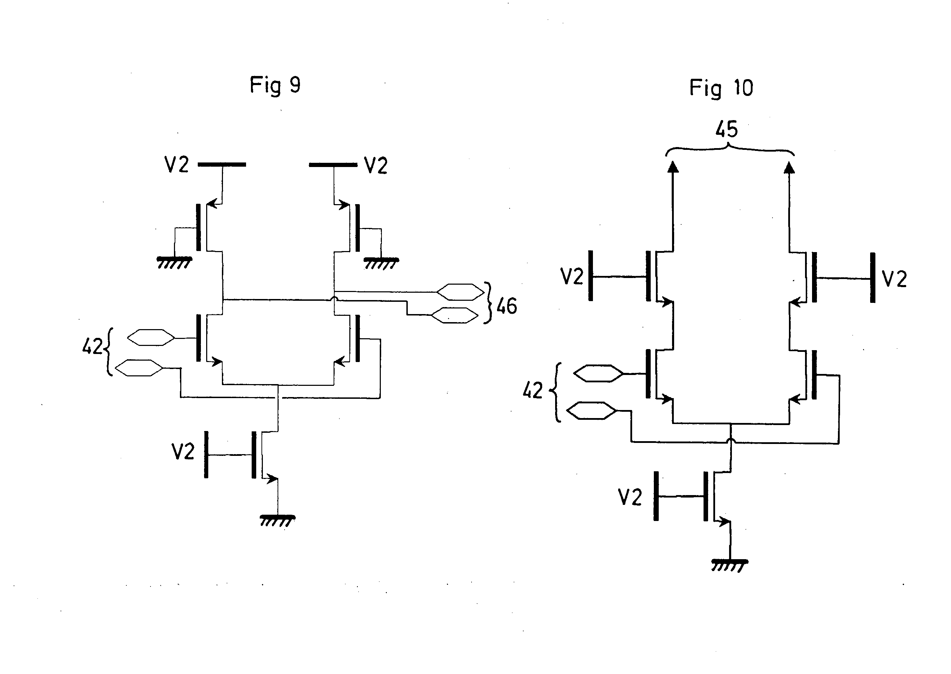

Le premier étage d'adaptation 43 est un circuit réalisant une conversion de la tension présente sur la sortie 42 du générateur d'impulsions 40, en courant injecté dans l'oscillateur verrouillé par injection. La figure 10 illustre un exemple de circuit électronique à topologie différentielle de ce premier étage d'adaptation 43.

Le deuxième étage d'adaptation 44 est un étage adaptant l'amplitude de la tension présente sur la sortie 42 du générateur d'impulsions 40 à l'entrée 28 du comparateur de phase. La figure 9 illustre un exemple de réalisation à topologie différentielle de ce deuxième étage d'adaptation 44.

### EXEMPLE

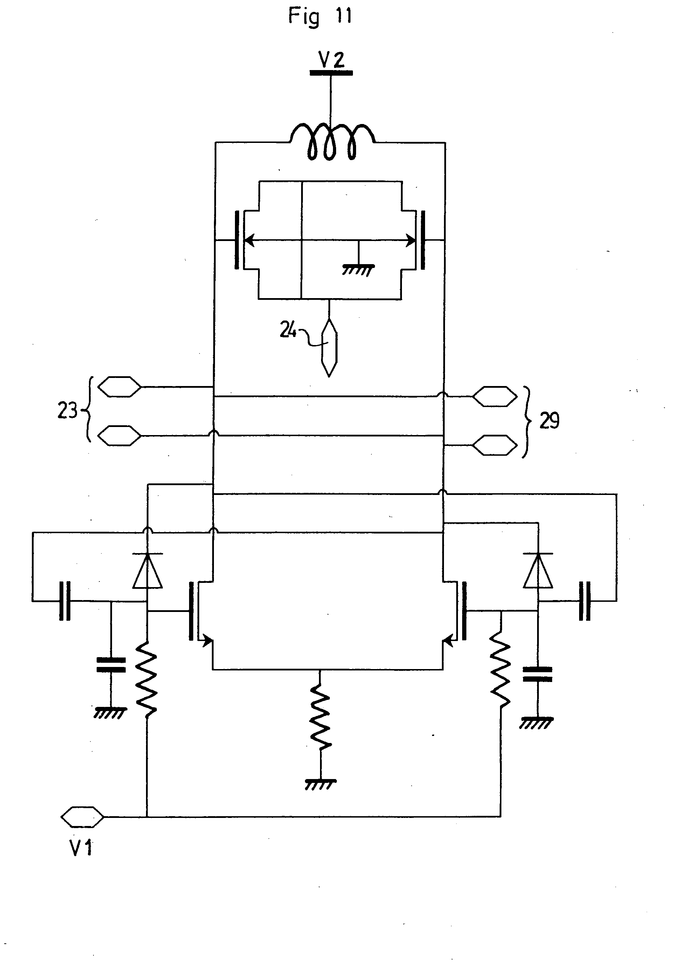

On a réalisé un prototype d'un dispositif selon l'invention conforme au circuit électronique représenté figure 11, sous forme d'un circuit ASIC en technologie CMOS 0,13 µm de chez STMicroelectronics. Ce prototype encapsulé en boîtier a été reporté sur un circuit imprimé verre-téflon. Egalement ce prototype en puce nue a été reporté sur un substrat alumine. Ces deux reports ont permis de valider l'ensemble du fonctionnement de cette architecture qui a satisfait avec succès des tests de caractérisation électrique complets, y compris lors d'essais thermiques jusqu'à 85°C. De plus, ce prototype a été soumis à des essais sous faisceau laser où des erreurs n'ont pu être déclenchées qu'avec un laser à la plus haute puissance envisageable pour ce type d'essai, c'est à dire 200 pico-joules, équivalent à un LET ("Linear Energy Transfer", énergie de transfert linéaire) approximativement de 50 MeV/mg/cm2. Des essais sous faisceau d'ions lourds ont également été réalisés, et il a fallu atteindre un LET de 64 MeV/mg/cm2 pour déclencher des erreurs. Dans tous les cas, le nombre d'erreurs observées a été particulièrement réduit.

En particulier, les résultats suivants ont été obtenus :
- plage du niveau d'entrée des données du type PRBS (« Pseudo Random Bit Sequence ») 2¹¹ : 150 mV à plus de 1 V,
- plage de tension d'alimentation : 1,15 V à plus de 1,45 V,
- ouverture de l'oeil des bits de données et déphasage («jitter») : oeil 240 mV 60 ps en PRBS 2⁷ à 10 Gbit/s,
- le taux d'erreurs mesuré est resté inférieur à 10⁻¹¹ de 9,6 Gbit/s à 10,2 Gbit/s sans réglage.

L'invention peut faire l'objet de très nombreuses variantes de réalisation par rapport aux exemples de réalisation représentée sur les figures et décrits ci-dessus. En particulier, les différents composants du dispositif (oscillateur, générateurs d'impulsions, comparateur de phase, filtre de boucle,...) peuvent être réalisés par d'autres structures de circuit, connues en elles-mêmes, et procurant les mêmes fonctions.

## Revendications

1. Dispositif d'extraction d'horloge et de données numériques à partir d'un signal série en bande de base, dit signal reçu, représentatif des données numériques et codé avec un signal d'horloge présentant une fréquence d'horloge bits fsr, comprenant :
- un circuit (12) d'extraction d'horloge relié à une entrée, dite entrée de réception (10), recevant le signal reçu et comprenant :
- un oscillateur verrouillé en injection (19) comprenant au moins une borne, dite entrée en courant (23), recevant un signal issu du signal reçu et cadencé à la fréquence d'horloge bits fsr, et délivrant, sur au moins une borne, dite sortie d'horloge (29), un signal d'horloge, dit signal d'horloge de réception, synchronisé et en phase avec la fréquence d'horloge bits fsr du signal reçu,
- une boucle d'asservissement en phase (25) comprenant :
- une première entrée (27) reliée à une sortie d'horloge (29) de l'oscillateur verrouillé en injection,
- une deuxième entrée (28) alimentée par un signal issu du signal reçu,
- et une sortie (36) délivrant un signal en tension analogique, dit signal de commande, reliée à une entrée, dite entrée de commande (24), de l'oscillateur (19) adaptée pour que la valeur de la fréquence propre fos de l'oscillateur (19) dépende de la valeur du signal de commande reçu sur cette entrée de commande (24), la valeur du signal de commande étant adaptée soit pour être sans effet sur l'oscillateur (19) lorsque la différence de phase entre la première entrée (27) et la deuxième entrée (28) est nulle, soit pour modifier la fréquence propre fos de telle sorte que cette dernière prenne la valeur de la fréquence d'horloge bits fsr du signal d'horloge de réception,
- un circuit, dit générateur d'impulsions de phase (30), générant un signal d'impulsions à la fréquence de fronts du signal reçu avec une durée et une amplitude des impulsions adaptées aux caractéristiques de fonctionnement de la boucle d'asservissement en phase (25), et délivrant ces impulsions sur une seule sortie (31) reliée uniquement à ladite deuxième entrée (28) de la boucle d'asservissement en phase (25),
- un circuit (20, 40, 43) générateur d'impulsions de synchronisation générant un signal d'impulsions de courant, à la fréquence de fronts du signal reçu, sur une sortie unique (22, 45) reliée uniquement à l'entrée en courant (23) de l'oscillateur verrouillé en injection (19),
- un circuit d'échantillonnage (15) du signal reçu avec le signal d'horloge de réception, ce circuit d'échantillonnage (15) ayant une première entrée, dite entrée de signal (17), reliée à l'entrée de réception (10), et une deuxième entrée, dite entrée d'horloge (18), reliée à au moins une sortie d'horloge (29) de l'oscillateur verrouillé en injection, ce circuit d'échantillonnage (15) étant adapté pour délivrer sur au moins une borne, dite sortie de données (16), des données numériques transmises par le signal reçu,
- au moins un circuit déphaseur (37) adapté pour introduire une différence de phase prédéterminée constante entre l'entrée de signal (17) et l'entrée d'horloge (18) du circuit d'échantillonnage (15), la différence de phase totale entre ces deux entrées (17, 18) résultant de chaque circuit déphaseur (37) étant adaptée pour garantir un alignement en phase du signal à l'entrée de signal (17) et du signal à l'entrée d'horloge (18).

2. Dispositif selon la revendication 1, **caractérisé en ce que** la boucle d'asservissement en phase (25) comprend un circuit comparateur de phase (26) comprenant une première entrée (27) reliée à la sortie d'horloge (29), une deuxième entrée (28) reliée à la sortie (31) du générateur d'impulsions de phase (30), et une sortie (33) délivrant un signal analogique dont l'amplitude est fonction de la différence de phase entre la première entrée (27) et la deuxième entrée (28), et **en ce que** le générateur d'impulsions de phase (30) est adapté pour générer un signal d'impulsions avec une durée et une amplitude des impulsions adaptées aux caractéristiques de fonctionnement de ce comparateur de phase (26).

3. Dispositif selon la revendication 2, **caractérisé en ce que** ladite sortie (33) du comparateur de phase (26) est reliée à l'entrée (34) d'un filtre de boucle (35), ce filtre de boucle (35) comprenant une sortie (36) délivrant le dit signal de commande.

4. Dispositif selon l'une des revendications 1 à 3, **caractérisé en ce que** ledit générateur d'impulsions de phase (30) est adapté pour délivrer un signal d'impulsions en tension.

5. Dispositif selon l'une des revendications 1 à 4, **caractérisé en ce que** le générateur d'impulsions de phase (30) est adapté pour délivrer des impulsions ayant une largeur égale à la moitié de la durée nominale d'un bit du signal reçu.

6. Dispositif selon l'une des revendications 1 à 5, **caractérisé en ce que** le comparateur de phase (26) est formé d'une porte OU exclusif.

7. Dispositif selon l'une des revendications 1 à 6, **caractérisé en ce que** l'oscillateur verrouillé en injection (19) est du type formé d'un circuit résonnant LC.

8. Dispositif selon la revendication 7, **caractérisé en ce que** l'oscillateur verrouillé en injection (19) comprend deux branches comprenant chacune un transistor à effet de champ à résistance négative, les deux transistors étant couplés selon une topologie différentielle.

9. Dispositif selon l'une des revendications 1 à 8, **caractérisé en ce qu'**il est exempt de tout moyen de réglage externe.

10. Dispositif selon l'une des revendications 1 à 9, **caractérisé en ce que** le circuit d'échantillonnage (15) est formé d'une bascule D.

11. Dispositif selon l'une des revendications 1 à 10, **caractérisé en ce qu'**il est réalisé selon une architecture différentielle.

12. Dispositif selon l'une des revendications 1 à 11, **caractérisé en ce qu'**il est réalisé sous forme d'au moins un circuit intégré incorporant au moins l'oscillateur verrouillé en injection (19).

13. Dispositif selon l'une des revendications 1 à 12, **caractérisé en ce qu'**il est adapté pour pouvoir fonctionner avec une fréquence d'horloge bits fsr supérieure à 500 MHz.

## Patentansprüche

1. Vorrichtung zur Extraktion von Takt und digitalen Daten aus einem seriellen Basisband-Signal, Empfangssignal genannt, das digitale Daten repräsentiert und mit einem Taktsignal codiert ist, das eine Taktfrequenz bits fsr aufweist, umfassend:
- eine Schaltung (12) zur Taktextraktion, die mit einem Eingang, Empfangseingang (10) genannt, verbunden ist, der das Empfangssignal entgegennimmt, und Folgendes umfasst:
-- einen Injektionssynchron-Oszillator (19), der mindestens einen Anschluss, Stromeingang (23) genannt, umfasst, der ein Signal entgegennimmt, das vom Empfangssignal abgeleitet und mit der Taktfrequenz bits fsr getaktet ist, und an mindestens einem Anschluss, Taktausgang (29) genannt, ein Taktsignal, Empfangstaktsignal genannt, abgibt, das mit der Taktfrequenz bits fsr des Empfangssignals synchronisiert und in Phase ist,
-- einen Phasenregelkreis (25), umfassend:
--- einen ersten Eingang (27), der mit einem Taktausgang (29) des Injektionssynchron-Oszillators verbunden ist,
--- einen zweiten Eingang (28), der von einem vom Empfangssignal abgeleiteten Signal gespeist wird,
--- und einen Ausgang (36), der ein Analogspannungssignal, Steuersignal genannt, abgibt und mit einem Eingang, Steuereingang (24) genannt, des Oszillators (19) verbunden ist und sich derart verhält, dass der Wert der Eigenfrequenz fos des Oszillators (19) vom Wert des über diesen Steuereingang (24) empfangenen Steuersignals abhängt, wobei der Wert des Steuersignals derart bemessen ist, dass es entweder ohne Wirkung auf den Oszillator (19) ist, wenn nämlich die Phasendifferenz zwischen dem ersten Eingang (27) und dem zweiten Eingang (28) null ist, oder die Eigenfrequenz fos derart modifiziert, dass diese Letztere den Wert der Taktfrequenz bits fsr des Empfangstaktsignals annimmt,
-- eine Schaltung, Phasenimpulsgenerator (30) genannt, die ein Impulssignal mit der Frequenz der Flanken des Empfangssignals bei einer Dauer und einer Amplitude der Impulse, die an die Betriebseigenschaften des Phasenregelkreises (25) angepasst sind, erzeugt und diese Impulse über einen einzigen Ausgang (31) abgibt, der nur mit dem zweiten Eingang (28) des Phasenregelkreises (25) verbunden ist,
-- eine Synchronisationsimpulsgeneratorschaltung (20, 40, 43), die ein Stromimpulssignal mit der Frequenz der Flanken des Empfangssignals an einem einzigen Ausgang (22, 45) erzeugt, der nur mit dem Stromeingang (23) des Injektionssynchron-Oszillators (19) verbunden ist,
- eine Schaltung (15) zum Abtasten des Empfangssignals mit dem Empfangstaktsignal, wobei diese Abtastschaltung (15) einen ersten Eingang, Signaleingang (17) genannt, der mit dem Empfangseingang (10) verbunden ist, und einen zweiten Eingang, Takteingang (18) genannt, der mit mindestens einem Taktausgang (29) des Injektionssynchron-Oszillators verbunden ist, aufweist, wobei diese Abtastschaltung (15) dafür eingerichtet ist, an mindestens einem Anschluss, Datenausgang (16) genannt, vom Empfangssignal übertragene digitale Daten abzugeben,
- mindestens eine Phasenschieberschaltung (37), die dafür eingerichtet ist, eine vorgegebene konstante Phasendifferenz zwischen den Signaleingang (17) und den Takteingang (18) der Abtastschaltung (15) einzubringen, wobei die Gesamtphasendifferenz zwischen diesen beiden Eingängen (17, 18), die durch diese Phasenschieberschaltung (37) entsteht, derart bemessen ist, dass ein Phasenabgleich des Signals am Signaleingang (17) und des Signals am Takteingang (18) gewährleistet ist.

2. Vorrichtung nach Anspruch 1, **dadurch gekennzeichnet, dass** der Phasenregelkreis (25) eine Phasenkomparatorschaltung (26) mit einem ersten Eingang (27), der mit dem Taktausgang (29) verbunden ist, einem zweiten Eingang (28), der mit dem Ausgang (31) des Phasenimpulsgenerators (30) verbunden ist, und einem Ausgang (33), der ein Analogsignal abgibt, dessen Amplitude eine Funktion der Phasendifferenz zwischen dem ersten Eingang (27) und dem zweiten Eingang (28) ist, umfasst, und dadurch, dass der Phasenimpulsgenerator (30) dafür eingerichtet ist, ein Impulssignal mit einer Dauer und einer Amplitude der Impulse zu erzeugen, die an die Betriebseigenschaften dieses Phasenkomparators (26) angepasst sind.

3. Vorrichtung nach Anspruch 2, **dadurch gekennzeichnet, dass** der Ausgang (33) des Phasenkomparators (26) mit dem Eingang (34) eines Schleifenfilters (35) verbunden ist, wobei dieses Schleifenfilter (35) einen Ausgang (36) umfasst, der das Steuersignal abgibt.

4. Vorrichtung nach einem der Ansprüche 1 bis 3, **dadurch gekennzeichnet, dass** der Phasenimpulsgenerator (30) dafür eingerichtet ist, ein Spannungsimpulssignal abzugeben.

5. Vorrichtung nach einem der Ansprüche 1 bis 4, **dadurch gekennzeichnet, dass** der Phasenimpulsgenerator (30) dafür eingerichtet ist, Impulse abzugeben, die eine Breite aufweisen, die gleich der Hälfte der Nenndauer eines Bits des Empfangssignals ist.

6. Vorrichtung nach einem der Ansprüche 1 bis 5, **dadurch gekennzeichnet, dass** der Phasenkomparator (26) von einem Exklusiv-ODER-Gatter gebildet wird.

7. Vorrichtung nach einem der Ansprüche 1 bis 6, **dadurch gekennzeichnet, dass** der Injektionssynchron-Oszillator (19) von dem Typ ist, der von einem LC-Resonanzkreis gebildet wird.

8. Vorrichtung nach Anspruch 7, **dadurch gekennzeichnet, dass** der Injektionssynchron-Oszillator (19) zwei Zweige mit jeweils einem Feldeffekttransistor mit negativem Widerstand umfasst, wobei die beiden Transistoren gemäß einer differentiellen Topologie gekoppelt sind.

9. Vorrichtung nach einem der Ansprüche 1 bis 8, **dadurch gekennzeichnet, dass** sie frei von externen Regelungsmitteln ist.

10. Vorrichtung nach einem der Ansprüche 1 bis 9, **dadurch gekennzeichnet, dass** die Abtastschaltung (15) von einer Kippschaltung D gebildet wird.

11. Vorrichtung nach einem der Ansprüche 1 bis 10, **dadurch gekennzeichnet, dass** sie gemäß einer differentiellen Architektur verwirklicht ist.

12. Vorrichtung nach einem der Ansprüche 1 bis 11, **dadurch gekennzeichnet, dass** sie in Form mindestens einer integrierten Schaltung verwirklicht ist, die mindestens einen Injektionssynchron-Oszillator (19) enthält.

13. Vorrichtung nach einem der Ansprüche 1 bis 12, **dadurch gekennzeichnet, dass** sie dafür eingerichtet ist, mit einer Taktfrequenz bits fsr arbeiten zu können, die höher als 500 MHz ist.

## Claims

1. Device for extracting a clock signal and digital data from a baseband serial signal, named signal received, representing the digital and encoded data with a clock signal having a bit clock frequency fsr, comprising:
- a clock extraction circuit (12) connected to an input, named receiving input (10), receiving the signal received and comprising:
-- an injection-locked oscillator (19), comprising at least one terminal, named the current input (23), receiving a signal derived from the signal received and having a rate at the bit clock frequency fsr, and transmitting, over at least one terminal, named clock output (29), a clock signal, named receiving clock signal, synchronised and in phase with the bit clock frequency fsr of the signal received,
-- a phase-lock loop (25) comprising:
--- a first input (27) connected to a clock output (29) of the injection-locked oscillator,
--- a second input (28) fed by a signal derived from the signal received,
--- and an output (36) transmitting an analogue voltage signal, named control signal, connected to an input, named control input (24), of the oscillator (19), adapted so that the value of the natural frequency fos of the oscillator (19) depends on the value of the control signal received over this control input (24), the value of the control signal being adapted either to have no effect on the oscillator (19) when the phase difference between the first input (27) and the second input (28) is zero, or to modify the natural frequency fos such that the latter takes on the value of the bit clock frequency fsr of the receiving clock signal,
-- a circuit, named phase pulse generator (30), generating a pulse signal at the frequency of the received signal fronts with a pulse amplitude and duration adapted to the operating characteristics of the phase-lock loop (25), and transmitting these pulses over a single output (31) solely connected to said second input (28) of the phase-lock loop (25),
-- a synchronisation pulse generator circuit (20, 40, 43), generating a current pulse signal, at the frequency of the received signal fronts, over a single output (22, 45) solely connected to the current input (23) of the injection-locked oscillator (19),
- a sampling circuit (15) for sampling the signal received with the receiving clock signal, this sampling circuit (15) having a first input, named signal input (17), connected to the receiving input (10), and a second input, named clock input (18), connected to at least one clock output (29) of the injection-locked oscillator, this sampling circuit (15) being adapted to transmit over at least one terminal, named data output (16), digital data transmitted by the signal received,
- at least one phase shifter circuit (37) adapted to introduce a constant pre-determined phase difference between the signal input (17) and the clock input (18) of the sampling circuit (15), the total phase difference between these two inputs (17, 18) resulting from each phase shifter circuit (37) being adapted to ensure a phase alignment of the signal at the signal input (17) and of the signal at the clock input (18).

2. Device according to claim 1, **characterised in that** the phase-lock loop (25) comprises a phase comparator circuit (26) comprising a first input (27) connected to the clock output (29), a second input (28) connected to the output (31) of the phase pulse generator (30), and an output (33) transmitting an analogue signal, the amplitude of which depends on the phase difference between the first input (27) and the second input (28), and **in that** the phase pulse generator (30) is adapted to generate a pulse signal with a pulse amplitude and duration adapted to the operating characteristics of this phase comparator (26).

3. Device according to claim 2, **characterised in that** said output (33) of the phase comparator (26) is connected to the input (34) of a loop filter (35), this loop filter (35) comprising an output (36) transmitting said control signal.

4. Device according to one of claims 1 to 3, **characterised in that** said phase pulse generator (30) is adapted to transmit a voltage pulse signal.

5. Device according to one of claims 1 to 4, **characterised in that** the phase pulse generator (30) is adapted to transmit pulses having a width equal to half of the nominal duration of a bit of the signal received.

6. Device according to one of claims 1 to 5, **characterised in that** the phase comparator (26) is formed from an exclusive-OR gate.

7. Device according to one of claims 1 to 6, **characterised in that** the injection-locked oscillator (19) is of the type formed from an LC resonant circuit.

8. Device according to claim 7, **characterised in that** the injection-locked oscillator (19) comprises two branches each comprising a negative resistance field-effect transistor, the two transistors being coupled according to a differential topology.

9. Device according to one of claims 1 to 8, **characterised in that** it is free from any external configuration means.

10. Device according to one of claims 1 to 9, **characterised in that** the sampling circuit (15) is formed from a D flip-flop.

11. Device according to one of claims 1 to 10, **characterised in that** it is produced according to a differential architecture.

12. Device according to one of claims 1 to 11, **characterised in that** it is produced in the form of at least one integrated circuit at least incorporating the injection-locked oscillator (19).

13. Device according to one of claims 1 to 12, **characterised in that** it is adapted to be able to operate with a bit clock frequency fsr exceeding 500 MHz.
